(19) Europäisches Patentamt
European Patent Office
Office européen des brevets

(11) EP 1 669 765 A1

(12) EUROPÄISCHE PATENTANMELDUNG

(43) Veröffentlichungstag:
**14.06.2006 Patentblatt 2006/24**

(51) Int Cl.:
***G01R 19/00*** *(2006.01)*

(21) Anmeldenummer: **05026567.7**

(22) Anmeldetag: **05.12.2005**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **13.12.2004 DE 102004059960**

(71) Anmelder: **Bourns, Inc.**
**Riverside,**
**California 92507 (US)**

(72) Erfinder: **Berton, Farhad, Dr.-Ing.**
**86187 Augsburg (DE)**

(74) Vertreter: **von Bülow, Tam**
**Patentanwaltskanzlei**
**Mailänder Strasse 13**
**81545 München (DE)**

# (54) Schaltungsanordnung zur Messung eines elektrischen Stromes

(57) Die Schaltungsanordnung zur Messung eines durch einen hochohmigen Verbraucher (R1) fließenden elektrischen Stromes enthält eine Stromspiegelschaltung (1), in deren ersten Zweig (T1) der hochohmige Verbraucher in Reihe geschaltet ist und deren zweiter Zweig mit einer Auswerteschaltung (3, 4, 5) verbunden ist. Der hochohmige Verbraucher ist insbesondere eine Lambda-Sonde (R1) des Katalysators einer Verbrennungskraftmaschine, dessen Widerstandswert in der Größenordnung von mehreren Megaohm liegt und der bei hoher Betriebstemperatur von ca. 400 °C betrieben wird. Dementsprechend müssen sehr kleine Ströme in der Größenordnung von einigen Nanoamper bis einigen Mikroamper gemessen werden. Durch die Stromspiegelschaltung wird im zweiten Zweig ein Strom ($I_{D2}$) erzeugt, der gleichgroß dem durch den ersten Zweig und den Verbraucher (R1) fließenden Strom ($I_{D1}$) ist. Der durch den zweiten Zweig fließende Strom belastet somit den ersten Zweig nicht. Sämtliche Bauteile können in einer integrierten Schaltung, wie z.B. einem ASIC, integriert sein.

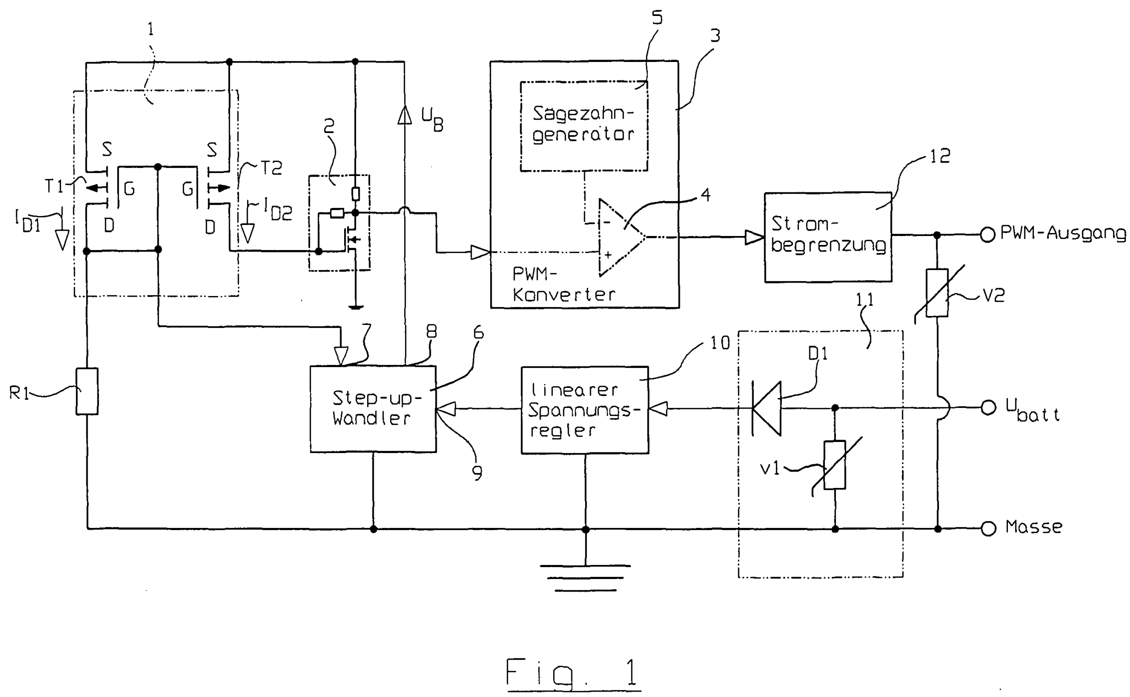


Fig. 1

EP 1 669 765 A1

## Beschreibung

Die Erfindung bezieht sich auf eine Schaltungsanordnung zur Messung eines elektrischen Stromes.

Die DE 198 44 465 A1 beschreibt eine Schaltungsanordnung zum Messen eines Stromes unter Verwendung einer Stromspiegelschaltung, die einen ersten Zweig und einen zweiten Zweig aufweist, wobei an den ersten Zweig der Verbraucher und an den zweiten Zweig eine Auswerteschaltung angeschlossen sind. Der erste Zweig besteht dort aus einer Reihenschaltung aus einem Shunt-Widerstand, einem Transistor, zwei weiteren Widerständen und einem Schalttransistor, dessen Emitter mit Masse verbunden ist. Zwischen den Shunt-Widerstand und den erst genannten Transistor ist eine ohmsche Last als Verbraucher angeschlossen. Der zweite Zweig der Stromspiegelschaltung besteht aus einer Reihenschaltung aus einem Widerstand, einem Transistor und einem weiteren Widerstand, wobei die Stromspiegelschaltung dadurch realisiert ist, daß die Basisanschlüsse der beiden Transistoren miteinander verbunden sind. Weiterhin ist dort vorgesehen, daß zur Spannungsstabilisierung im ersten Zweig der Stromspiegelschaltung eine Zenerdiode parallel zu Schaltung aus Shunt-Widerstand, erstem Transistor und Widerstand geschaltet ist. Bei dieser Schaltungsanordnung ist der durch den Shunt-Widerstand fließende Strom an der Stromspiegelschaltung verzweigt, so daß ein erster Teilstrom durch den Verbraucher und ein zweiter Teilstrom durch den ersten Zweig der Stromspiegelschaltung fließt. Somit ist der Strom im zweiten Zweig der Stromspiegelschaltung nicht mit dem zu messenden Strom durch den Verbraucher identisch, so daß die Meßgenauigkeit für die Messung des Stromes durch den Verbraucher gering ist und auch in dieser Schrift nur mit ca. 5% angegeben wird. Im übrigen ist der Verbraucher dort relativ niederohmig, da es sich um eine Lampe eines Kraftfahrzeuges handeln soll. Der Laststrom liegt daher auch in der Größenordnung von etwa 4A bis 12A.

Die US 5,845,275 zeigt eine Schaltungsanordnung zur Messung eines elektrischen Stromes mit einem nicht linearen Element zur Strom-Spannungswandlung in Form eines Fuzzy-Logic-Prozessors mit einem nicht linearen Halbleiterelement.

Die EP 1 298 778 A2 beschreibt eine Konstantstromquelle, in deren Regelkreis ein Sägezahngenerator verwendet wird.

Die EP 1 372 261 A1 zeigt eine Strommeßschaltung mit einer Stromspiegelschaltung, die aus MOS-Transistoren aufgebaut ist. Die dortige Schaltung wird dazu verwendet, einen elektrischen Strom für eine Photodiode zu regeln.

Die EP 1 211 776 A2 beschreibt schließlich ein induktives Energieverteilungssystem, mit einer Schaltung, die die Ausgangsspannung innerhalb vorgegebener Grenzen halten soll, wenn aufgrund von Induktivitäten Resonanzen auftreten.

Die vorliegende Erfindung setzt sich zum Ziel, sehr kleine elektrische Ströme im Bereich von einigen nA bis einigen μA zu messen. Solch kleine Ströme treten bei Lambda-Sonden, die in Katalysatoren von Verbrennungskraftmaschinen eingesetzt werden, auf. Dieser sehr kleine elektrische Strom zeigt die von der Lambda-Sonde zu erfassende Gaskonzentration an. Der Widerstandswert üblicher Lambda-Sonden liegt in der Größenordnung von ca. 500 kOhm bis einigen MOhm, wie z.B. 5 MOhm. Bei den üblichen Betriebsspannungen in Kraftfahrzeugen ist dann der durch die Lambda-Sonde fließende Strom in der Größenordnung der oben genannten einigen nA bis einigen μA. Die üblichen Lambda-Sonden sind auf der Basis von Keramikmaterial hergestellt und werden bei hohen Temperaturen in der Größenordnung von 400°C betrieben. Bei diesen hohen Temperaturen steigt der elektrische Widerstandswert dann noch weiter an. Dementsprechend sind die durch die Lambda-Sonde fließenden und damit zu messenden Ströme extrem klein.

In der Praxis hat man deshalb zur Strommessung sehr genaue Präzisionsmeßwiderstände verwendet, die mit Hilfe von Laserstrahlen getrimmt und an den jeweiligen Meßbereich angepaßt wurden. Das Laser-Trimmen von Meßwiderständen ist sehr aufwendig. Weiter sind solche Meßwiderstände relativ stark temperaturabhängig und haben eine schlechte elektromagnetische Verträglichkeit gegen Störfelder. Deshalb ist der Einsatz solcher Präzisionsmeßwiderstände in schwierigen Umgebungsbedingungen, wie z.B. Kraftfahrzeugen, problematisch, neben dem hohen Aufwand und den Kosten für die Herstellung.

Aufgabe der Erfindung ist es daher, eine Schaltungsanordnung für die Messung sehr kleiner elektrischer Ströme zu schaffen, die bei geringem Herstellaufwand ein hochgenaues Meßergebnis liefert und störunanfälliger ist.

Diese Aufgabe wird durch die im Patentanspruch 1 angegebenen Merkmale gelöst. Vorteilhafte Ausgestaltungen und Weiterbildungen der Erfindung sind den Unteransprüchen zu entnehmen.

Das Grundprinzip der Erfindung liegt darin, eine Stromspiegelschaltung zu verwenden, in deren ersten Zweig der hochohmige Verbraucher angeordnet ist und deren zweiter Zweig mit einer Auswerteschaltung verbunden ist. Bei einer Stromspiegelschaltung fließt in beiden Zweigen ein gleichgroßer elektrischer Strom. Der Strom durch den ersten Zweig und den Verbraucher, wie z.B. eine Lambda-Sonde, wird sozusagen in den zweiten Kreis gespiegelt, wobei der zweite Kreis den ersten Kreis nicht belastet und damit das Meßergebnis auch nicht verfälscht. Um derart kleine Ströme in einer Auswerteschaltung weiter verarbeiten zu können, ist an den zweiten Zweig der Stromspiegelschaltung ein Transimpedanzverstärker angeschlossen, der den Strom durch den zweiten Zweig in einen Spannungswert umwandelt und somit eine Signalaufbereitung für die Auswerteschaltung durchführt.

Nach einer vorteilhaften Weiterbildung der Erfindung ist der elektrische Verbraucher eine Lambda-Sonde mit einem Widerstandswert in der Größenordnung von 500 kOhm bis ca. 5 MOhm.

Nach einer vorteilhaften Weiterbildung ist die Signalaufbereitung ein PWM-Konverter, der das an ihm anliegende Eingangssignal in ein pulsweitenmoduliertes Signal umwandelt. Dies hat den Vorteil, daß das pulsweitenmodulierte Signal auch bei störanfälliger Umgebung, wie in einem Kraftfahrzeug, über weite Strecken störfest übertragen werden kann. Vorzugsweise besteht der PWM-Konverter aus einem Komparator und einem Sägezahngenerator.

Nach einer anderen Weiterbildung der Erfindung wird die Stromspiegelschaltung mit einer höheren Betriebsspannung betrieben als der in einem Fahrzeug vorhandenen Batteriespannung. Zu diesem Zweck ist ein Step-up-Wandler oder eine Charge-pump vorgesehen, die aus der vorhandenen Batteriespannung die höhere Betriebsspannung für die Stromspiegelschaltung erzeugt.

Vorzugsweise arbeitet der Step-up-Wandler bzw. die Charge-pump lastabhängig in der Weise, daß die Schaltfrequenz in Abhängigkeit vom Strom durch den Verbraucher verändert wird. Dies hat den Zweck, der Stromspiegelschaltung eine konstante Betriebsspannung zuzuführen, unabhängig von der jeweiligen Last.

Nach einer anderen Weiterbildung der Erfindung haben der Spannungsversorgungseingang der gesamten Schaltung und/oder der Signalausgang der Schaltung jeweils eine Schutzschaltung gegen Überspannung und elektrostatische Aufladungen, was vorzugsweise durch einen Varistor realisiert ist.

Nach einer anderen Weiterbildung der Erfindung ist die gesamte Schaltungsanordnung mit Ausnahme der Last als integrierte Schaltung (ASIC) aufgebaut.

Im folgenden wird die Erfindung anhand eines Ausführungsbeispieles im Zusammenhang mit der Zeichnung ausführlicher erläutert. Es zeigt:

Fig. 1 ein Blockschaltbild der Schaltungsanordnung nach der Erfindung; und

Fig. 2 ein Diagramm des Stromes über der Drain-Source-Spannung der Stromspiegelschaltung.

Fig. 1 zeigt die Schaltungsanordnung nach der Erfindung, mit der der durch einen Verbraucher R1 fließende elektrische Strom gemessen werden soll. Der Verbraucher R1 ist hier als Widerstand dargestellt. Es kann sich beispielsweise um eine Lambda-Sonde handeln, die bei normalem Betrieb (beispielsweise mit einer Umgebungstemperatur von ca. 400 °C) einen sehr hohen Widerstandswert in der Größenordnung von einigen Megaohm hat. Zur Messung des durch diesen Verbraucher R1 fließenden Stromes ist eine Stromspiegelschaltung 1 vorgesehen, die zwei parallele Zweige aufweist, die jeweils durch einen Transistor T1 und T2 gebildet werden. Vorzugsweise werden selbstsperrende FET-Transistoren verwendet, die im Abschnürbereich arbeiten. Die Source-Anschlüsse S der beiden Transistoren T1 und T2 sind miteinander verbunden und werden mit einer Betriebsspannung $U_B$ versorgt, auf die weiter unten noch eingegangen wird. Der Drain-Anschluß D des Transistors T1 im ersten Zweig ist mit dem Verbraucher R1 verbunden, dessen anderer Anschluß auf Masse liegt. Die Gate-Anschlüsse G der beiden Transistoren T1 und T2 sind miteinander verbunden und mit dem Drain-Anschluß des Transistors T1. Aufgrund der Kurzschlußverbindung zwischen Gate und Drain des ersten Transistors T1 gilt:

$$U_{DS} = U_{GS} \text{ und } U_{GD} = 0$$

Der durch den Verbraucher R1 fließende Strom $I_{D1}$, der auch über die Source-Drain-Strecke des Transistors T1 fließt, entspricht aufgrund der Eigenschaft der Stromspiegelschaltung exakt auch dem Strom $I_{D2}$, der über die Source-Drain-Strecke des zweiten Transistors T2 fließt. Dieser Strom $I_{D2}$ wird einem Eingang eines Transimpedanzverstärkers 2 zugeführt, in eine proportionale Spannung umgewandelt und gelangt von dort in einen PWM-Konverter 3, der das Ausgangssignal des Transimpedanzverstärkers 2 in ein pulsweitenmoduliertes Signal umwandelt. Der PWM-Konverter 3 enthält beispielsweise einen Komparator 4, dessen einem Eingang das Ausgangssignal des Transimpedanzverstärkers 2 und dessen anderem Eingang das Ausgangssignal eines Sägezahngenerators 5 zugeführt wird. Der Sägezahngenerator 5 erzeugt in bekannter Weise ein zeitlich linear ansteigendes und nahezu senkrecht abfallendes periodisches Ausgangssignal. Überschreitet die Sägezahnspannung des Sägezahngenerators 5 die Ausgangsspannung des Transimpedanzverstärkers, so schaltet der Komparator 4 um (von "High" auf "Low" oder von "Low" auf "High", je nach Polarität an den Anschlüssen), womit ein pulsweitenmoduliertes Signal gebildet wird.

Die Schaltungsanordnung nach der Erfindung soll primär zur Messung des Stromes durch eine Lambda-Sonde eines Kraftfahrzeuges eingesetzt werden. Die in Kraftfahrzeugen übliche Batteriespannung $U_{batt}$ liegt je nach Fahrzeugart bei den meisten Fahrzeugen bei 12 oder 24 Volt. Die meisten Lambda-Sonden dagegen müssen für einwandfreie Meßergebnisse mit höherer Betriebsspannung $U_B$ betrieben werden, die in der Größenordnung von 30 Volt liegt. Zur Wandlung der Batteriespannung $U_{batt}$ in die höhere Betriebsspannung $U_B$ ist ein Spannungswandler 6 vorgesehen, der vorzugsweise als Step-up-Wandler mit Charge-pump ausgebildet ist. Es kann aber auch ein Step-up-Wandler mit Induktivitäten verwendet werden. Solche an sich bekannten Wandler arbeiten mit elektronischen Schaltern, die je nach Last unterschiedlich schnell umgeschaltet werden, um an ihrem Ausgang eine konstante Spannung zu erzeugen. Der Step-up-Wandler 6 hat daher einen Steuereingang 7, der mit dem Drain-Anschluß D des Transistors T1 verbunden ist und somit in Abhängigkeit von der Größe des Stromes $I_{D1}$ die Schaltfrequenz des Step-up-Wandlers 6 so verändert, daß am Ausgang 8 des Step-up-Wandlers die gewünschte Spannung von beispielsweise 30 Volt anliegt. Diese Spannung $U_B$ wird den Source-Anschlüssen S der beiden Transistoren T1 und T2 zugeführt.

Ein Eingangsanschluß 9 des Step-up-Wandlers ist über einen linearen Spannungsregler 10 und eine Schutzschaltung 11 mit der Batteriespannung $U_{batt}$ verbunden. Die Schutzschaltung 11 enthält eine in Durchlaßrichtung geschaltete Diode D1, die als Verpolungsschutz dient, sowie einen Varistor V1, der als Schutz gegen Überspannung und statische Aufladungen dient. Solche Bauelemente werden auch als ESD-Schutz (Electrical Static Discharge Protection Device) bezeichnet und werden, wie dargestellt, zwischen Batteriespannung $U_{batt}$ und Masse geschaltet.

Der Ausgang des PWM-Konverters 3 ist in der Praxis beim Anwendungsfall der Strommessung bei einer Lambda-Sonde noch mit einer Strombegrenzungsschaltung 12 verbunden, die als Open-Drain-Ausgang ausgelegt ist. Auch dieser Ausgang kann noch mit einem ESD-Schutz in Form eines Varistors V2 versehen sein.

Die beiden Transistoren T1 und T2 sind vorzugsweise vom Anreicherungstyp (p-Kanal-Typ) und daher selbstsperrend.

Sämtliche Bauteile können in einem integrierten Schaltkreis, wie z.B. einem ASIC, zusammengefaßt sein.

Der Sägezahngenerator arbeitet bei einem Ausführungsbeispiel mit konstanter Frequenz von ca. 100 kHz. Das PWM-Signal am Ausgang des PWM-Konverters 3 hat damit im beschriebenen Anwendungsfall eine Auflösung von 10 Bit. Durch Erhöhung der Frequenz der Sägezahnspannung auf 400 kHz bzw. 1,6 MHz kann man auch eine Auflösung von 12 bzw. 14 Bit erreichen.

Im Zusammenhang mit Fig. 2 wird die Arbeitsweise der Stromspiegelschaltung 1 erläutert. Die selbstsperrenden FET-Transistoren T1 und T2 arbeiten im Abschnürbereich. Damit ergibt sich der Arbeitspunkt als Schnittpunkt der Widerstandsgeraden R1. Da der Transistor T2 mit derselben Spannung $U_{GS}$ wie der Transistor T1 gesteuert wird, ist der Drain-Strom $I_{D2}$ gleich dem Laststrom $I_{D1}$.

Abschließend sei noch erwähnt, daß einige der verwendeten Baugruppen als integrierte Schaltkreise im Handel erhältlich sind. Als linearer Spannungsregler 10 der Fig. 1 kann beispielsweise ein "Low-Dropout Linear Voltage Regulator" des Typs ADP667 der Firma Analog Devices verwendet werden. Als Step-up-Wandler 6 der Fig. 1 kann ein "Micropower Step-up DC/DC Converters in ThinSOT" des Typs LT1615 der Firma Linear Technology Corporation verwendet werden oder ein "Turboswitch in a PFC Boost Converter" des Typs AN603 der Firma STMicroelectronics.

**Patentansprüche**

1. Schaltungsanordnung zur Messung eines durch einen Verbraucher fließenden elektrischen Stromes mit einer Stromspiegelschaltung (1), die einen ersten Zweig (T1) und einen zweiten Zweig (T2) aufweist, wobei an den ersten Zweig (T1) der Verbraucher (R1) und an den zweiten Zweig (T2) eine Auswerteschaltung (3, 4, 5) angeschlossen sind,
   **dadurch gekennzeichnet,**
   **daß** der Verbraucher (R1) hochohmig ist,
   **daß** der Verbraucher (R1) in Reihenschaltung an den ersten Zweig. (T1) angeschlossen ist und
   **daß** zwischen den zweiten Zweig (T2) der Stromspiegelschaltung (1) und die Auswerteschaltung (3, 4, 5) ein Transimpedanzwandler (2) zwischengeschaltet ist.

2. Schaltungsanordnung nach Anspruch 1, **dadurch gekennzeichnet,**
   **daß** der Verbraucher (R1) eine Lambda-Sonde mit einem Widerstandswert in der Größenordnung von 500 k Ohm bis 5 M Ohm ist.

3. Schaltungsanordnung nach Anspruch 1 oder 2, **dadurch gekennzeichnet,**
   **daß** die Auswerteschaltung einen Spannungs/Pulsweitenmodulations-Konverter (3) aufweist.

4. Schaltungsanordnung nach Anspruch 3, **dadurch gekennzeichnet,**
   **daß** der Spannungs/Pulsweitenmodulations-Konverter einen Sägezahngenerator (5) und einen Komparator (4) aufweist, dessen einem Eingang das Ausgangssignal des Sägezahngenerators (5) und dessen anderem Eingang das Ausgangssignal der Stromspiegelschaltung (1) bzw. des Transimpedanzverstärkers (2) zugeführt wird.

5. Schaltungsanordnung nach einem der Ansprüche 1 bis 4, **dadurch gekennzeichnet,**
   **daß** die Stromspiegelschaltung (1) zwei selbstsperrende Feldeffekttransistoren (T1, T2) vom Anreicherungstyp aufweist.

6. Schaltungsanordnung nach einem der Ansprüche 1 bis 5, **dadurch gekennzeichnet,**
   **daß** eine Stromversorgung für die Stromspiegelschaltung (1) durch einen Step-up-Wandler (6) erfolgt, der mit einer Batteriespannung ($U_{batt}$) gespeist wird und eine demgegenüber höhere Ausgangsspannung ($U_B$) erzeugt.

7. Schaltungsanordnung nach Anspruch 6, **dadurch gekennzeichnet,**
   **daß** ein Zweig der Stromspiegelschaltung (1) mit einem Steuereingang (7) des Step-up-Wandlers (6) verbunden ist, über den die Schaltfrequenz des Step-up-Wandlers (6) in Abhängigkeit von dem durch diesen Zweig der Stromspiegelschaltung (1) fließenden Strom gesteuert wird.

**8.** Schaltungsanordnung nach Anspruch 6 oder 7, **dadurch gekennzeichnet,**
**daß** dem Step-up-Wandler (6) ein linearer Spannungsregler (10) vorgeschaltet ist.

**9.** Schaltungsanordnung nach einem der Ansprüche 6, 7 oder 8, **dadurch gekennzeichnet,**
**daß** dem Step-up-Wandler (6) eine Schutzschaltung (11) vorgeschaltet ist.

**10.** Schaltungsanordnung nach Anspruch 9, **dadurch gekennzeichnet,**
**daß** die Schutzschaltung (11) mindestens einen Varistor (V1) aufweist.

**11.** Schaltungsanordnung nach Anspruch 9 oder 10, **dadurch gekennzeichnet,**
**daß** die Schutzschaltung eine in Durchlaßrichtung geschaltete Diode (D1) aufweist.

**12.** Schaltungsanordnung nach Anspruch 3 oder 4, **dadurch gekennzeichnet,**
**daß** dem Spannungs/Pulsweitenmodulations-Konverter ein Strombegrenzungsschaltkreis (12) nachgeschaltet ist.

**13.** Schaltungsanordnung nach Anspruch 3, 4 oder 12, **dadurch gekennzeichnet,**
**daß** dem Spannungs/Pulsweitenmodulations-Konverter (3) oder dem Strombegrenzungsschaltkreis (12) ein Varistor (V2) nachgeschaltet ist.

**14.** Schaltungsanordnung nach einem der Ansprüche 1 bis 13, **dadurch gekennzeichnet,**
**daß** alle Baugruppen der Schaltungsanordnung mit Ausnahme des Verbrauchers (R1) in einem integrierten Schaltkreis zusammengefaßt sind.

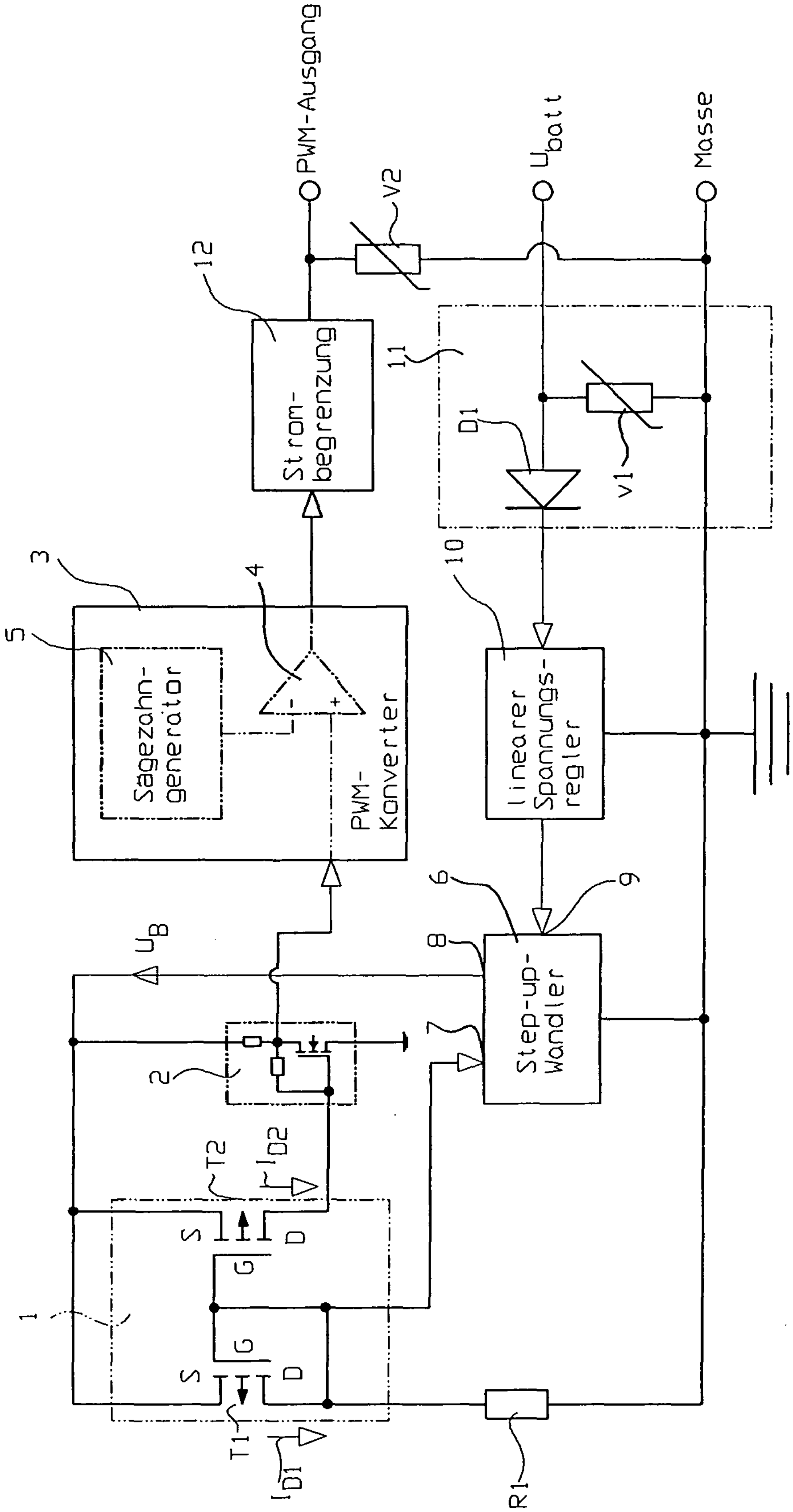
PWM-Ausgang
$U_{batt}$
Masse
V2
12
Strom-
begrenzung
11
D1
V1
3
5
Sägezahn-
generator
4
PWM-
Konverter
10
linearer
Spannungs-
regler
$U_B$
6
9
8
Step-up-
Wandler
2
7
T2
$I_{D2}$
S
G
D
1
T1
$I_{D1}$
R1

Fig. 1

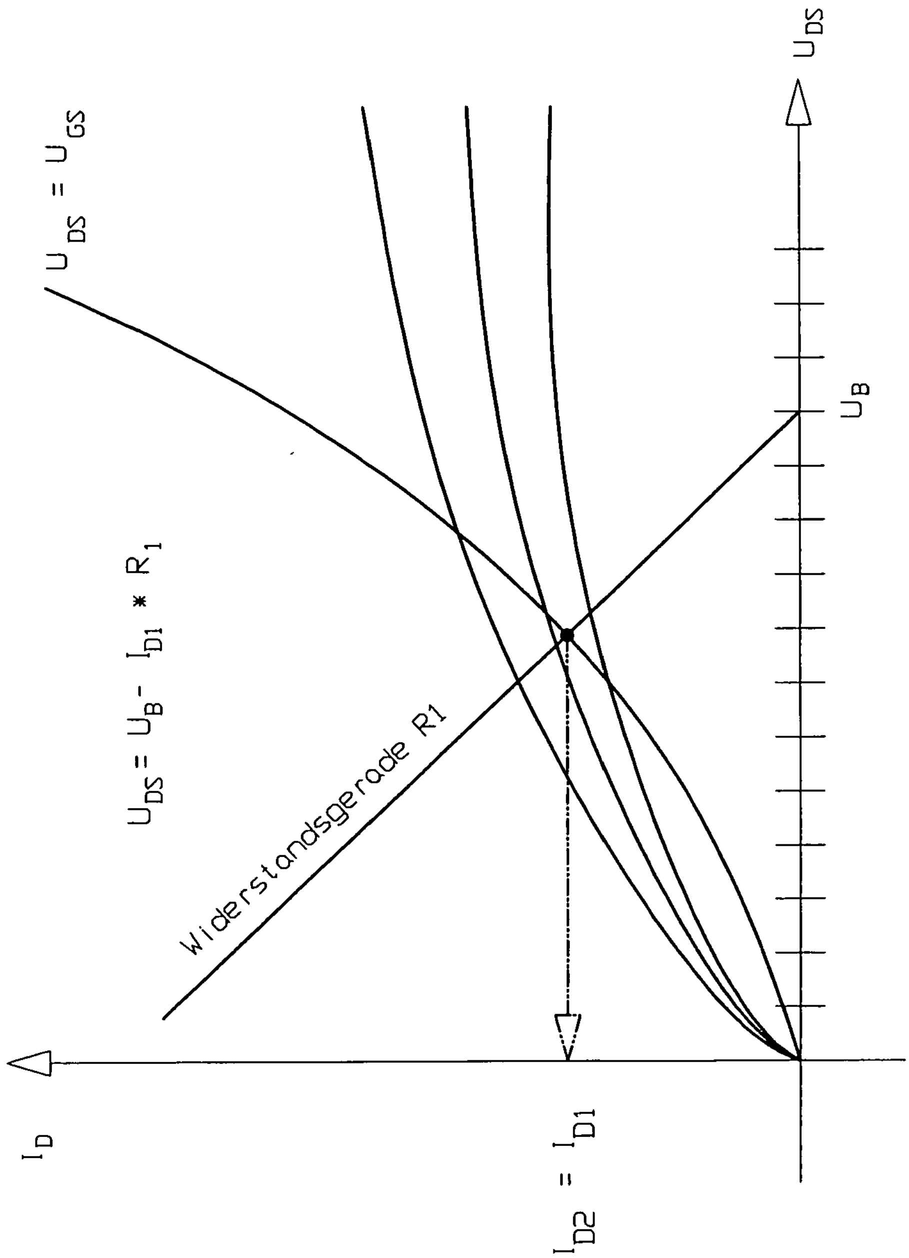


Fig. 2

Europäisches Patentamt

# EUROPÄISCHER RECHERCHENBERICHT

Nummer der Anmeldung
EP 05 02 6567

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 5 323 115 A (WERNER, JR. ET AL) 21. Juni 1994 (1994-06-21) * Spalte 5, Zeile 25 - Spalte 8, Zeile 7; Abbildungen 1,2 * ----- | 1 | G01R19/00 |
| X | DE 103 11 096 A1 (INSTITUT FUER MIKROELEKTRONIK UND MECHATRONIK SYSTEME GGMBH) 23. Oktober 2003 (2003-10-23) * Absatz [0029] - Absatz [0030]; Abbildung 1 * * Absatz [0033] - Absatz [0034]; Abbildungen 3,4 * ----- | 1 | |
| A | US 6 084 418 A (TAKAMI ET AL) 4. Juli 2000 (2000-07-04) * Zusammenfassung; Abbildungen 1,8 * ----- | 1 | |
| A | EP 0 525 656 A (SGS-THOMSON MICROELECTRONICS S.R.L; MARELLI AUTRONICA S.P.A; STMICROEL) 3. Februar 1993 (1993-02-03) * Zusammenfassung; Abbildung 3 * ----- | 1 | RECHERCHIERTE SACHGEBIETE (IPC): G01R F02D |

Der vorliegende Recherchenbericht wurde für alle Patentansprüche erstellt

| Recherchenort | Abschlußdatum der Recherche | Prüfer |
|---|---|---|
| München | 27. März 2006 | Hijazi, A |

2

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

**ANHANG ZUM EUROPÄISCHEN RECHERCHENBERICHT ÜBER DIE EUROPÄISCHE PATENTANMELDUNG NR.** EP 05 02 6567

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

27-03-2006

| Im Recherchenbericht angeführtes Patentdokument | Datum der Veröffentlichung | Mitglied(er) der Patentfamilie | Datum der Veröffentlichung |
|---|---|---|---|
| US 5323115 A | 21-06-1994 | DE 69313718 D1 | 16-10-1997 |
| | | DE 69313718 T2 | 12-03-1998 |
| | | EP 0570148 A2 | 18-11-1993 |
| | | JP 3373587 B2 | 04-02-2003 |
| | | JP 6034688 A | 10-02-1994 |
| | | US 5270660 A | 14-12-1993 |
| DE 10311096 A1 | 23-10-2003 | KEINE | |
| US 6084418 A | 04-07-2000 | KEINE | |
| EP 0525656 A | 03-02-1993 | DE 69226831 D1 | 08-10-1998 |
| | | DE 69226831 T2 | 14-01-1999 |
| | | ES 2120974 T3 | 16-11-1998 |
| | | IT 1250825 B | 21-04-1995 |
| | | JP 5206757 A | 13-08-1993 |
| | | US 5276405 A | 04-01-1994 |

EPO FORM P0461

Für nähere Einzelheiten zu diesem Anhang : siehe Amtsblatt des Europäischen Patentamts, Nr.12/82